# EUROPÄISCHE PATENTSCHRIFT

(11) **EP 1 002 352 B1**
(45) Veröffentlichungstag und Bekanntmachung des Hinweises auf die Patenterteilung: **24.10.2001**
(21) Anmeldenummer: 98931883.7
(22) Anmeldetag: 24.07.1998
(51) Int. Cl.: H02B 1/56, H05K 7/20

(54) **SCHRANKARTIGES GEHÄUSE**
CABINET TYPE BOX
BOITE DU TYPE ARMOIRE

(30) Priorität: 05.08.1997 CH 185697
(43) Veröffentlichungstag der Anmeldung: 24.05.2000
(73) Patentinhaber: Almatec AG Für Elektroschrank-Technik, 6170 Schüpfheim (CH)
(72) Erfinder: HERTLI, Alfred, D-6170 Schüpfheim (CH)
(74) Vertreter: Hug Interlizenz AG
(86) Internationale Anmeldenummer: CH9800319
(87) Internationale Veröffentlichungsnummer: WO9908354

(56) Entgegenhaltungen:
- DE-A- 19 545 448
- DE-C- 19 609 845
- DE-U- 8 309 697
- DE-U- 29 519 260

## Beschreibung

### TECHNISCHES GEBIET

Die vorliegende Erfindung bezieht sich auf das Gebiet der Gehäusetechnik. Sie betrifft ein schrankartiges Gehäuse, insbesondere für den Ausseneinsatz, zur Aufnahme von Wärme erzeugenden, insbesondere elektrischen und/oder elektronischen, Baueinheiten, bei welchem Gehäuse ein Innenraum von Wänden umschlossen ist, welche Wände zumindest teilweise doppelwandig mit einer Aussenwand und einer Innenwand und einem zwischen Aussenwand und Innenwand angeordneten Zwischenraum ausgebildet sind, wobei die Innenwand aus dem Innenraum zumindest einen Teil der von den Baueinheiten erzeugten Wärme aufnimmt, wobei erste Mittel vorhanden sind, welche zur Kühlung des Innenraums einen Luftstrom durch den Zwischenraum, erzeugen, wobei das Gehäuse ein Dach aufweist, welches ein Zwischendach und ein über dem Zwischendach angeordnetes Oberdach umfasst, welches von dem Zwischendach beabstandet ist und seitlich über das Zwischendach greift, und wobei das Zwischendach über den nach oben offenen Zwischenraum der doppelwandigen Wand greift.

### STAND DER TECHNIK

Ein schrankartiges Gehäuse der vorgenannten Art ist aus der DE U 295 19 260 bekannt.

Für die gegen klimatische Einwirkungen und hinsichtlich der Abgabe elektromagnetischer Störstrahlung abgeschirmte Unterbringung von elektrischen und/oder elektronischen Geräten und Baugruppen der Telekommunikation, Verkehrsleittechnik, Hochspannungs- und Mittelspannungstechnik, insbesondere auch im Aussenbereich, werden im Stand der Technik unterschiedliche schrankartige Gehäuse eingesetzt. Derartige meist rechteckige Gehäuse umschliessen mit metallischen Wänden allseitig einen Innenraum, in welchem die Geräte untergebracht sind. Häufig sind für den erleichterten Zugang bei Installation, Wartung und Reparatur auf der Vorderseite des Gehäuses verschliessbare Türen vorgesehen. Bei Gehäusen für den Einsatz im Aussenbereich wird auf der Oberseite meist zusätzlich ein Dach angeordnet, welches das Gehäuse gegen Regen und Sonneneinstrahlung schützt.

Die Schutzfunktion, insbesondere auch die elektromagnetische Abschirmfunktion des Gehäuses bringt es mit sich, dass der Innenraum gegenüber dem umgebenden Aussenraum mittels geeigneter Dichtungen relativ dicht abgeschlossen ist. Dies hat zugleich den Vorteil, dass die im Gehäuse befindlichen Geräte und Baugruppen weitgehend vor Staub und Nässe, aber auch Termiten oder dgl., geschützt sind. Sofern die Geräte und Baugruppen während ihres Betriebs Wärme erzeugen, wird diese Wärme von der erwärmten Luft im Innenraum und/oder durch Wärmestrahlung auf die Wände des Gehäuses übertragen und von deren Aussenseite durch Luftkonvektion und/oder Wärmestrahlung an die Umgebung abgegeben.

Problematisch wird diese Art der Wärmeableitung bzw. Kühlung jedoch, wenn im Inneren des Gehäuses sehr viel Wärme erzeugt wird, oder wenn durch starke Sonneneinstrahlung das Gehäuse von aussen zusätzlich aufgeheizt wird. Spezielle (reflektierende) Beschichtungen der Gehäuseaussenflächen können den Einfluss der Sonneneinstrahlung zwar herabsetzen, die negativen Folgen einer starken Wärmeentwicklung im Inneren können dadurch jedoch nicht wirksam verhindert werden. Die Wärmeabführung aus dem Innenraum verschlechtert sich dagegen, wenn aus Stabilitätsgründen anstelle einfacher Wände doppelwandig ausgebildete Wände eingesetzt werden, weil der Wärmetransport von innen nach aussen in diesem Fall durch zusätzliche Grenzflächen behindert wird. Eine gute Wärmeabfuhr aus dem Innenraum lässt sich dann zwar immer noch dadurch erreichen, dass mittels eines beispielsweise auf der Oberseite des Gehäuses angeordneten Ventilators ein kühlender Luftstrom von unten nach oben durch den (mit Lüftungsöffnungen versehenen) Innenraum des Gehäuses gesaugt wird; jedoch muss mit dieser Art der forcierten Kühlung der vorteilhafte Abschluss des Innenraums gegenüber dem Aussenraum aufgegeben werden.

Es ist andererseits auch bekannt, im Inneren eines solchen Gehäuses zur Wärmeabfuhr spezielle Kühlaggregate bzw. Klimageräte anzuordnen, jedoch verbrauchen derartige Kühlaggregate bzw. Klimageräte relativ viel Strom. Ein solch hoher Stromverbrauch ist aber in denen Fällen nicht tolerierbar, wo die in dem Gehäuse untergebrachten Geräte und Baugruppen im Rahmen einer Notstromversorgung aus einer lokalen Batterie notversorgt werden müssen.

### DARSTELLUNG DER ERFINDUNG

Es ist daher Aufgabe der Erfindung, ein Gehäuse zu schaffen, welches mit vergleichsweise einfachen Mitteln und geringem Energieaufwand, ohne wesentliche Platzeinbusse und ohne notwendige Verbindung zwischen Innen- und Aussenraum eine wirkungsvolle Abführung der im Innenraum erzeugten Wärme gewährleistet und insbesondere auch für den Einsatz im Aussenbereich geeignet ist.

Die Aufgabe wird bei einem Gehäuse der eingangs genannten Art dadurch die Merkmale des Anspruchs 1 gelöst. Der Kern der Erfindung besteht darin, mittels der doppelwandigen Wände einen äusseren Kühlkreislauf aufzubauen, welcher trotz vollständiger Trennung vom Innenraum eine wirkungsvolle Abfuhr der durch die Innenwand nach aussen transportierten Wärme ermöglicht. Durch die Doppelwand kann der kühlende Luftstrom sehr eng an der zu kühlenden Innenwand geführt werden. Da durch den Luftstrom direkt die Innenwand gekühlt wird, wird ein negativer Einfluss der anderen Grenzflächen (Aussenwand) der Doppelwand auf die Kühlung vermieden. Da die Doppelwand gleichzeitig zur mechanischen Festigkeit des Gehäuses beiträgt, ergeben sich aus der erfindungsgemässen Konstruktion zusätzliche Vorteile. Die Luftführung durch die Zwischenräume zwischen Innen- und Aussenwand und die Verwendung eines Oberdachs, eines Zwischendachs und den zweiten Mitteln ergibt somit einen Wärmetauscher, der gleichzeitig als Schutzgehäuse dient.

Eine erste bevorzugte Ausführungsform der Erfindung zeichnet sich dadurch aus, dass die spaltförmige Öffnung zwischen dem Zwischendach und und dem Oberdach nach unten gerichtet ist.

Diese Anordnung gewährleistet einen optimalen Schutz des Gehäuses vor Eindringen von Regen, Schmutz und Staub.

Grundsätzlich kann der kühlende Luftstrom durch die Zwischenräume in den doppelwandigen Wänden auf sehr verschiedene Weise, z.B. durch thermische Konvektion, durch die Ausnutzung von Wind o.ä. erzeugt werden. Eine bevorzugte zweite Ausführungsform der Erfindung zeichnet sich jedoch dadurch aus, dass die ersten Mittel wenigstens einen Ventilator umfassen. Durch den Einsatz eines Ventilators kann in bewährter Weise und an die jeweiligen Bedürfnisse optimal angepasst ein Luftstrom durch die Zwischenräume erzeugt werden.

Eine bevorzugte Weiterbildung dieser Ausführungsform zeichnet sich dadurch aus, dass der wenigstens eine Ventilator im Zwischendach eingebaut ist, dass der Zwischenraum zwischen Innen- und Aussenwand nach oben hin offen ist und dort mit dem wenigstens einen Ventilator in Verbindung steht, und dass der Zwischenraum weiterhin nach unten hin offen ist und dort mit der Umgebung des Gehäuses in Verbindung steht. Weiterhin bevorzugt saugt so der unter dem Oberdach geschützte und wenig Platz beanspruchende Ventilator durch den Zwischenraum hindurch am unteren Ende des Zwischenraums Luft aus der Umgebung des Gehäuses. Durch die von unten nach oben gerichtete Strömung der kühlenden Luft wird die natürliche Konvektionsströmung unterstützt, bei welcher die erwärmte Luft nach oben aufsteigt. Zugleich kann durch diese Art der Anordnung bei kurzen Strömungswegen die gesamte Länge der Wände mit dem kühlenden Luftstrom beaufschlagt werden.

Eine weitere bevorzugte Ausführungsform der Erfindung zeichnet sich dadurch aus, dass alle doppelwandig ausgebildeten Wände jeweils aus vertikal angeordneten Hohlkammerprofilen zusammengesetzt sind, und dass als Hohlkammerprofile Aluminium-Hohlprofile verwendet werden. Durch die Verwendung von einzelnen Hohlkammerprofilen aus Aluminium können die doppelwandigen Wände sehr leicht und kostengünstig nach dem Baukastenprinzip in verschiedenen Grössen und mit hoher mechanischer Stabilität aufgebaut werden. Aluminium-Hohlprofile haben neben den günstigen Kosten aber auch den Vorteil sehr guter thermischer Eigenschaften.

Der Wärmeübergang vom Innenraum zu den Kühlluftströmen lässt sich weiter verbessern, wenn gemäss einer anderen bevorzugten Ausführungsform der Erfindung die Innenwände der doppelwandig ausgeführten Wände dritte Mittel zur Vergrösserung der Wärmeübergangsfläche aufweisen, und die dritten Mittel Kühlrippen umfassen.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden.
Es zeigen
- Fig. 1: im vereinfachten Längsschnitt ein bevorzugtes Ausführungsbeispiel eines erfindungsgemässen Gehäuses;
- Fig. 2: den vereinfachten Querschnitt durch ein Gehäuse gemäss Fig. 1, dessen Wände aus einzelnen Hohlkammerprofilen aufgebaut sind;
- Fig. 3: im Querschnitt ein beispielhaftes Hohlkammerprofil für den Aufbau eines Gehäuses gemäss Fig. 2; und
- Fig. 4: das Gehäuse gemäss Fig. 1 mit zusätzlichen Mitteln im Innenraum zur Erzeugung von zwei getrennten Kühlkreisläufen.

### WEGE ZUR AUSFÜHRUNG DER ERFINDUNG

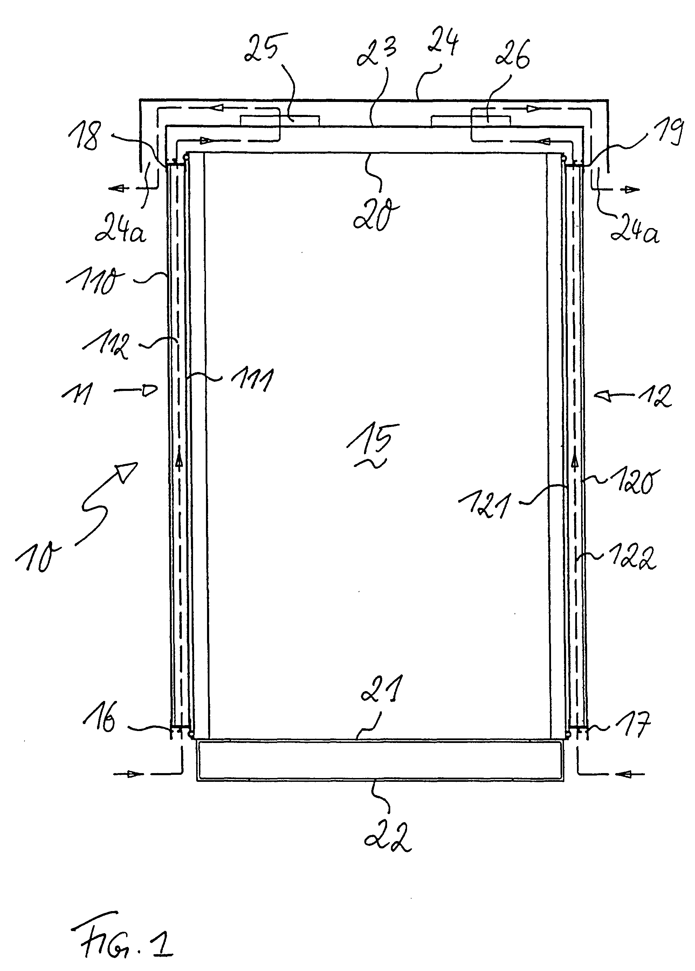

In Fig. 1 ist im vereinfachten Längsschnitt ein bevorzugtes Ausführungsbeispiel eines erfindungsgemässen Gehäuses wiedergegeben. Das Gehäuse 10 umschliesst mit Wänden, zu denen eine linke Seitenwand 11 und eine rechte Seitenwand 12 gehören, einen Innenraum 15, in welchem die (nicht dargestellten) Wärme erzeugenden Baueinheiten oder Geräte geschützt untergebracht sind. Der Innenraum 15 ist auf der Oberseite durch eine Dichtblech 20 und auf der Unterseite durch ein Bodenblech abgeschlossen und elektromagnetisch abgeschirmt. Das Gehäuse 10 ist erhöht auf einem Sockel 22 angeordnet, damit Luft von unten her freien Zutritt zu den Unterseiten der Seitenwände 11, 12 (und der anderen Wände) hat.

Zur Wärmeabfuhr aus dem Innenraum sind die Seitenwände 11, 12 (und die anderen Wände) doppelwandig ausgebildet und bestehen jeweils aus einer Innenwand 111 bzw. 121 und einer Aussenwand 110 bzw. 120, zwischen denen ein freier Zwischenraum 112 bzw. 122 verbleibt. Der mittlere Abstand zwischen Innenwand und Aussenwand beträgt beispielsweise 30 mm, kann aber je nach den Bedürfnissen auch anders gewählt werden. Die Zwischenräume 112, 122 in den Wänden 11, 12 sind nach unten und nach oben hin offen. Dazu sind Oeffnungen in den die Wände 11, 12 umschliessenden Umreifungsprofilen 16-19 vorgesehen. Durch die Zwischenräume 112, 122 der Wände 11, 12 wird nun zur Kühlung, vorzugsweise von unten nach oben, ein Luftstrom geschickt, wie dies in Fig. 1 durch die mit Pfeilen versehenen Strömungslinien angedeutet ist. Die Luft wird auf der Unterseite der Wände 11, 12 aus der Umgebung des Gehäuses 10 angesaugt und tritt oben wieder aus den Wänden 11, 12 aus. Beim Durchströmen der Zwischenräume 112, 122 nehmen die Luftströme Wärme aus den Innenwänden 111, 121 auf und transportieren diese Wärme in die Umgebung ab.

Zur Erzeugung des kühlenden Luftstromes sind Ventilatoren 25, 26 vorgesehen, die flach liegend in einem Zwischendach 23 angeordnet sind. Das Zwischendach 23, welches beispielsweise aus einem Blech besteht, ist in einem Abstand (z.B. 20 mm) oberhalb des Dichtbleches 20 angeordnet. Es greift über die nach oben offenen Zwischenräume 112, 122 der doppelwandigen Wände 11, 12 und schliesst mit der zugehörigen Aussenwand 110 bzw. 120 bzw. den Aussenkanten der die Wände 11, 12 abschliessenden Umreifungsprofile 18, 19 ab. Hierdurch wird zwischen dem Dichtblech 20 und dem Zwischendach 23 ein flacher Zwischenraum gebildet, in welchen die Luftströme aus den Zwischenräumen 112, 122 der Wände 11, 12 einströmen können und von dort durch die Ventilatoren 25, 26 nach oben abgesaugt werden. Die Ventilatoren 25, 26 (und das gesamte Gehäuse 10) sind nach oben hin durch ein Oberdach 24 geschützt, welches mit Abstand (z.B. 65 mm) oberhalb des Zwischendaches 23 angeordnet ist und seitlich unter Freilassung einer spaltförmigen, vorzugsweise nach unten gerichteten, (z.B. 20 mm breiten) Oeffnung 24a über das Zwischendach 23 greift. Durch den zwischen Zwischendach 23 und Oberdach 24 gebildeten Zwischenraum wird die von den Ventilatoren 25, 26 abgesaugte Luft seitlich und nach unten aus den Oeffnungen 24a in die Umgebung herausgedrückt. Die überkragende Ausbildung des Oberdaches 24 verhindert dabei, dass Regen in die Oeffnungen 24a eindringen kann.

Durch die beschriebene Führung der Kühlluftströme in den Zwischenräumen 112, 122 der doppelwandigen Wände 11, 12 und den Zwischenräumen oberhalb des Dichtbleches 20 wird ein externer Kühlkreislauf zwischen Umgebung und Innenwänden 111, 121 etabliert, der vom Innenraum 15 vollständig getrennt ist. Die Wärmeabfuhr erfolgt durch forcierte Kühlung, ohne das Kühlluft durch den Innenraum 15 geführt werden muss. Die Kapselung des Innenraumes 15, die aus Gründen der Abschirmung und der Dichtheit gegen Staub, Nässe und dgl. besonders vorteilhaft ist, braucht daher bei dieser Art der Kühlung nicht aufgegeben zu werden. Die Kühlleistung des Systems hängt von verschiedenen Parametern wie z.B. der Förderleistung der Ventilatoren 25, 26, dem Querschnitt und Strömungswiderstand der Lüftungskanäle, der Strömungsgeschwindigkeit, dem Wärmeübergang zwischen Innenwänden 111, 121 und Luftstrom ab. Bewährt hat sich in der Praxis eine Auslegung des Systems, bei der die Lufteintrittsgeschwindigkeit an der Unterseite der Wände 11, 12 gleichmässige 2 m/s beträgt. Der Wärmeübergang an den Innenwänden 111, 121 wird durch Kühlrippen an den Innenwänden 111, 121 optimiert, auf die weiter unten noch näher eingegangen wird. Bezüglich der Ventilatoren 25, 26 ist es im Hinblick auf den gewünschten geringen Energieverbrauch vorteilhaft, langsamlaufende Ventilatortypen mit grossem Durchmesser einzusetzen.

Der Aufbau der doppelwandigen Wände 11, 12 kann grundsätzlich dadurch erfolgen, dass einzelne Platten, welche die späteren Innen- und Aussenwände bilden, parallel zueinander angeordnet und durch Abstandhalter miteinander verbunden (verschraubt oder verschweisst) werden. Ein solcher Aufbau ist jedoch vergleichsweise unflexibel, aufwendig und teuer. Es wird daher bei der Realisierung des erfindungsgemässen Gehäuses für den Aufbau der doppelwandigen Wände 11, 12 vorzugsweise eine andere Technik eingesetzt, bei welcher einzelne (längliche) Hohlkammerprofile parallel aneinandergesetzt werden. Derartige Hohlkammerprofile können als Aluminium-Strangprofile in den unterschiedlichsten Profilformen leicht und preiswert hergestellt werden und bilden stabile, gut wärmeleitende Wandelemente, aus denen die hohlen Wände des erfindungsgemässen Gehäuses modulartig in den gewünschten Abmessungen aufgebaut werden. Darüber hinaus ist es bei derartigen Strangprofilen sehr einfach, an den Innenwänden Kühlrippen anzuformen, die den Wärmeübergang an diesen Wänden verbessern.

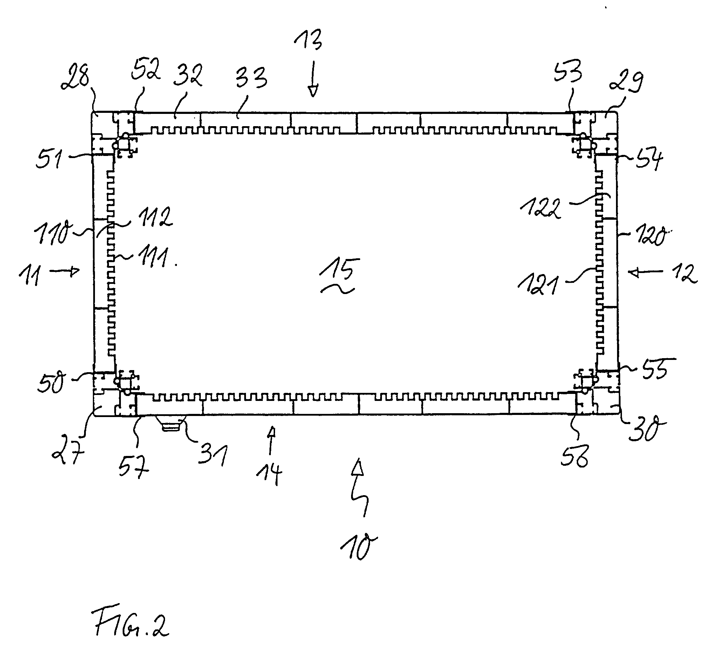

Mit derartigen Hohlkammerprofilen ergibt sich ein Aufbau des Gehäuses 10, wie er aus Fig. 2 im vereinfachten Querschnitt ersichtlich ist. Die Seitenwände 11, 12, die Vorderwand 13 und die Rückwand 14, die den Innenraum 15 umschliessen, sind hier aus einzelnen Hohlkammerprofilen 32, 33 zusammengesetzt. Die aneinandergrenzenden Kammern der Hohlkammerprofile 32, 33 bilden den durch Stege unterteilten Zwischenraum 112 bzw. 122. An den Innenwänden 111 bzw. 121 sind Kühlrippen 39 angeordnet, die sich auf einfache Weise dadurch ergeben, dass die Innenwände 111, 121 rechteckig (oder trapezförmig) gewellt ausgebildet sind. Die Wände 11-14 mit den aneinandergereihten Hohlkammerprofilen 32, 33 sind am Rand durch Umreifungsprofile 50-57 eingefasst. An den Ecken des Gehäuses 10 sind stabile Eckpfosten 27-30 vorgesehen, an welchen die Wände 11-14 befestigt sind. Im gezeigten Beispiel sind keine Türen vorgesehen. Türen in den verschiedensten Ausführungen (einflügelig, zweiflügelig, rechts oder links angeschlagen etc.) können aber selbstverständlich in die Wände 11-14 integriert werden. Auch kann ein Anschluss 31 vorgesehen sein.

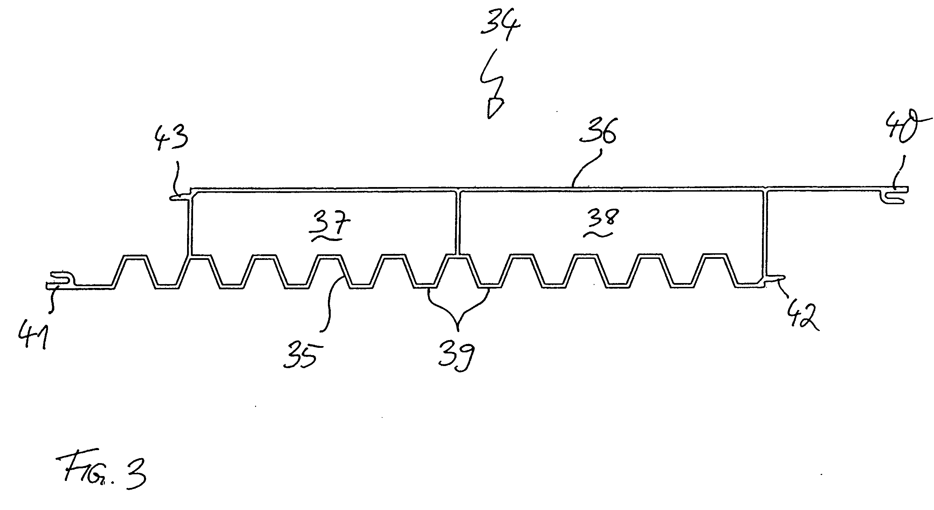

Ein bevorzugtes und beispielhaftes Hohlkammerprofil 34 für den Aufbau der doppelwandigen Wände ist in Fig. 3 im Querschnitt wiedergegeben. Das Aluminium-Strangprofil hat eine trapezförmig gewellte Innenwand 35 mit Kühlrippen 39 und eine glatte Aussenwand 36. Zwischen den Wänden 35, 36 sind als Zwischenraum zwei Kammern 37, 38 angeordnet, durch welche (senkrecht zur Zeichnungsebene) die Kühlluft geleitet werden kann. Die beiden Kammern sind durch durchgehende Stege begrenzt und getrennt, die dem Profil und damit auch der späteren Wand eine hohe mechanische Stabilität verleihen. Da die Wellung der Innenwand 35 bzw. die Kühlrippen 39 die Wand zusätzlich versteifen, können die Stege, welche die Kammern 37, 38 begrenzen, in grösserem Abstand bzw. in geringerer Anzahl angeordnet werden. Da die Stege die Haupt-Wärmebrücken in den Wänden bilden und im Falle einer Sonneneinstrahlung unerwünschte Wärme von aussen nach innen leiten, wird durch eine Verringerung der Stege der ungünstige Einfluss der Sonneneinstrahlung auf die Kühlung verringert. Die Hohlkammerprofile können an ihren Längskanten auf einfache Weise aneinander gereiht und ineinander gesteckt werden. Dazu sind auf beiden Seiten des Profils komplementäre Steckleisten 40, 42 und 41, 43 vorgesehen. Die aneinander gesteckten Hohlkammerprofile werden dann von den Umreifungsprofilen eingerahmt und zusammengehalten.

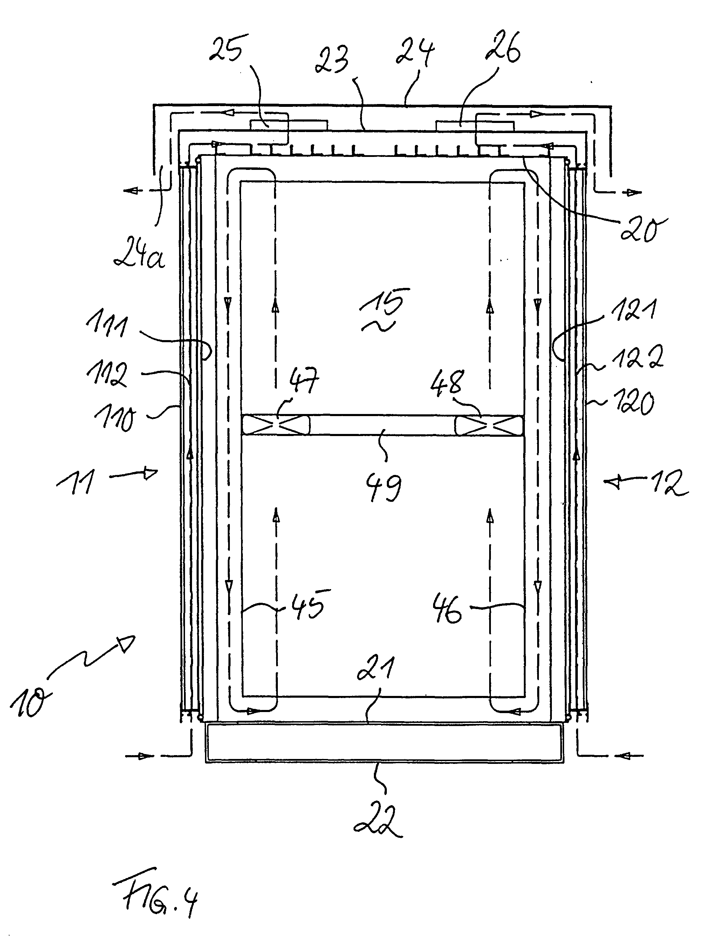

In Fig. 1 ist nur der externe Kühlkreislauf dargestellt, der die Wärme von den Innenwänden abführt und an die Umgebung abgibt. Um einen für die Wärmeabfuhr optimalen Uebergang der Wärme von den im Innenraum angeordneten Geräten und Baugruppen auf die Innenwände zu ermöglichen, wird vorzugsweise gemäss Fig. 4 im Innenraum 15 des Gehäuses 10 ein zweiter interner Kühlkreislauf installiert, der von dem externen Kühlkreislauf strömungsmässig vollständig getrennt ist. Der Wärmeaustausch zwischen den Kühlkreisläufen erfolgt hauptsächlich über die (gerippten) Innenwände der doppelwandigen Wände, die quasi als Wärmetauscher wirken, sowie zusätzlich über das obenliegende Dichtblech 20, welches zur Vergrösserung der Wärmeübergangsfläche mit Kühlrippen 44 (z.B. in Form von aufgesetzten Winkelprofilleisten) ausgerüstet ist.

Zum Aufbau des internen Kühlkreislaufs werden parallel zu den doppelwandigen Wänden 11, 12 im Abstand Leitbleche 45, 46 angeordnet, die zugleich als Seitenwände bei der Aufnahme von Einschubgehäusen dienen können. Auf einer flachen, wenig Platz beanspruchenden Zwischenebene 49 sind zwischen den Leitblechen 45, 46 Ventilatoren 47, 48 angeordnet, welche die Luft im Innenraum 15 derart umwälzen, dass sie entlang der gepfeilten, gestrichelten Linien zwischen den Leitblechen 45, 46 und den zugehörigen Innenwänden von oben nach unten, und im Innenraum zwischen den Leitblechen 45, 46 von unten nach oben strömt. Die Umwälzung erfolgt vorzugsweise mit einer Strömungsgeschwindigkeit von 0,7 m/s. Bei der Umlenkung des Luftstromes im oberen Bereich wird dabei verstärkt auch Wärme an das Dichtblech 20 abgegeben. Durch die entgegengesetzte Orientierung der Luftströme der beiden Kreisläufe auf der Aussen- und Innenseite der Innenwände wird ein optimaler Wärmeaustausch zwischen den Kühlkreisen bewirkt.

Durch die Verwendung eines speziellen Lackpulvers für die Beschichtung der Aussenwände 110, 120 und des Oberdachs 24, in welchem Lackpulver reflektierende Pigmente vorhanden sind, kann die äussere Aufwärmung des Gehäuses 10 durch Sonneneinstrahlung deutlich verringert und damit das Kühlungskonzept gemäss der Erfindung zusätzlich unterstützt werden.

Insgesamt ergibt sich mit der Erfindung ein Gehäuse, welches trotz einer praktisch vollständigen Abdichtung des Innenraumes eine gute Abführung der im Innenraum entstehenden Wärme nach aussen gewährleistet, mechanisch sehr stabil, einfach aufzubauen und insbesondere auch für den Ausseneinsatz geeignet ist.

### BEZEICHNUNGSLISTE

- 10: Gehäuse (schrankartig)
- 11,12: Seitenwand
- 13: Vorderwand
- 14: Rückwand
- 15: Innenraum
- 16, .., 19: Umreifungsprofil
- 20: Dichtblech
- 21: Bodenblech
- 22: Sockel
- 23: Zwischendach
- 24: Oberdach
- 24a: Oeffnung (spaltförmig)
- 25,26: Ventilator
- 27,..,30: Eckpfosten
- 31: Anschluss
- 32,33,34: Hohlkammerprofil
- 35: Innenwand (Hohlkammerprofil)
- 36: Aussenwand (Hohlkammerprofil)
- 37,38: Kammer
- 39,44: Kühlrippe
- 40, .., 43: Steckleiste
- 45,46: Leitblech
- 47,48: Ventilator
- 49: Zwischenebene
- 50-57: Umreifungsprofil
- 110: Aussenwand (Seitenwand 11)
- 111: Innenwand (Seitenwand 11)
- 112: Zwischenraum (Seitenwand 11)
- 120: Aussenwand (Seitenwand 12)
- 121: Innenwand (Seitenwand 12)
- 122: Zwischenraum (Seitenwand 12)

## Patentansprüche

1. Schrankartiges Gehäuse (10), insbesondere für den Ausseneinsatz, zur Aufnahme von Wärme erzeugenden, insbesondere elektrischen und/oder elektronischen, Baueinheiten, bei welchem Gehäuse (10) ein Innenraum (15) von Wänden (11, 12, 13, 14) umschlossen ist, welche Wände (11, 12, 13, 14) zumindest teilweise doppelwandig mit einer Aussenwand (110, 120) und einer Innenwand (111, 121) und einem zwischen Aussenwand (110, 120) und Innenwand (111, 121) angeordneten Zwischenraum (112, 122) ausgebildet sind, wobei die Innenwand (111, 121) aus dem Innenraum (15) zumindest einen Teil der von den Baueinheiten erzeugten Wärme aufnimmt, wobei erste Mittel (23, 24, 25, 26) vorhanden sind, welche zur Kühlung des Innenraums (15) einen Luftstrom durch den Zwischenraum (112, 122) erzeugen, wobei das Gehäuse (10) ein Dach (23, 24) aufweist, welches ein Zwischendach (23) und ein über dem Zwischendach (23) angeordnetes Oberdach (24) umfasst, welches von dem Zwischendach (23) beabstandet ist und seitlich über das Zwischendach (23) greift, und wobei das Zwischendach über den nach oben offenen Zwischenraum (112, 122) der doppelwandigen Wand (11, 12) greift,
**dadurch gekennzeichnet,**
**dass** das Oberdach unter Freilassung einer spaltförmigen Oeffnung (24a) seitlich über das Zwischendach greift, dass das Zwischendach (23) mit der zugehörigen Aussenwand (110, 120) abschliesst, und dass unterhalb des Zwischendaches (23) und davon beabstandet zweite Mittel (20) angeordnet sind, welche den Innenraum (15) nach oben hin abschliessen und seitlich an die Innenwand (111, 121) der doppelwandigen Wand (11, 12) anschliessen.

2. Gehäuse nach Anspruch 1, **dadurch gekennzeichnet, dass** die spaltförmige Oeffnung (24a) nach unten gerichtet ist.

3. Gehäuse nach einem der Ansprüche 1 und 2, **dadurch gekennzeichnet, dass** die ersten Mittel wenigstens einen Ventilator (25, 26) umfassen.

4. Gehäuse nach Anspruch 3, **dadurch gekennzeichnet, dass** der wenigstens eine Ventilator (25, 26) im Zwischendach (23) angeordnet ist, dass der Zwischenraum (112, 122) nach oben hin offen ist und dort mit dem wenigstens einen Ventilator (25, 26) in Verbindung steht, und dass der Zwischenraum (112, 122) nach unten hin offen ist und dort mit der Umgebung des Gehäuses (10) in Verbindung steht.

5. Gehäuse nach Anspruch 4, **dadurch gekennzeichnet, dass** der wenigstens eine Ventilator (25, 26) so eingebaut ist, dass er durch den Zwischenraum (112, 122) hindurch am unteren Ende des Zwischenraums (112, 122) Luft aus der Umgebung des Gehäuses (10) ansaugt und diese Luft in den Zwischenraum zwischen Zwischendach (23) und Oberdach (24) bläst.

6. Gehäuse nach einem der Ansprüche 1 bis 5, **dadurch gekennzeichnet, dass** das Gehäuse (10) zwei Seitenwände (11, 12), eine Vorderwand (13) und eine Rückwand (14) umfasst, und dass alle Wände (11,..,14) doppelwandig ausgebildet und von dem kühlenden Luftstrom durchströmt werden.

7. Gehäuse nach einem der Ansprüche 1 bis 6, **dadurch gekennzeichnet, dass** alle doppelwandig ausgebildeten Wände (11,..,14) jeweils aus vertikal angeordneten Hohlkammerprofilen (32, 33, 34) zusammengesetzt sind.

8. Gehäuse nach Anspruch 7, **dadurch gekennzeichnet, dass** als Hohlkammerprofile (32, 33, 34) Aluminium-Hohlprofile verwendet werden.

9. Gehäuse nach einem der Ansprüche 7 und 8, **dadurch gekennzeichnet, dass** die Hohlkammerprofile (32, 33, 34) jeweils nebeneinander mehrere Kammern (37, 38) aufweisen.

10. Gehäuse nach einem der Ansprüche 1 bis 9, **dadurch gekennzeichnet, dass** die Innenwände (111, 121) der doppelwandig ausgeführten Wände (11,..,14) dritte Mittel (39) zur Vergrösserung der Wärmeübergangsfläche aufweisen.

11. Gehäuse nach Anspruch 10, **dadurch gekennzeichnet, dass** die dritten Mittel Kühlrippen (39) umfassen.

12. Gehäuse nach Anspruch 11, **dadurch gekennzeichnet, dass** die Kühlrippen (39) durch eine wellenförmiges Querschnittsprofil der Innenwände (111, 121) gebildet werden.

13. Gehäuse nach einem der Ansprüche 1 bis 12, **dadurch gekennzeichnet, dass** die zweiten Mittel ein Dichtblech (20) umfassen, welches mit vierten Mitteln, vorzugsweise Kühlrippen (44), zur Vergrösserung der Wärmeübergangsfläche versehen ist.

14. Gehäuse nach einem der Ansprüche 1 bis 13, **dadurch gekennzeichnet, dass** der Innenraum (15) nach aussen hin abgeschlossen ist, und dass im Innenraum (15) fünfte Mittel (45,..,48) vorhanden sind, welche eine Zirkulation der im Innenraum (15) befindlichen Luft entlang der Innenwände (111, 121) der doppelwandig ausgebildeten Wände (11,..,14) bewirken.

15. Gehäuse nach Anspruch 14, **dadurch gekennzeichnet, dass** die Zirkulation der Luft entlang der Innenwände (111, 121) in vertikaler Richtung und entgegengesetzt zur Richtung des Luftstromes in den Zwischenräumen (112, 122) erfolgt.

16. Gehäuse nach einem der Ansprüche 14 und 15, **dadurch gekennzeichnet, dass** die fünften Mittel parallel zu den Innenwänden (111, 121) und davon beabstandet angeordnete Leitbleche (45, 46) und wenigstens einen zwischen den Leitblechen (45, 46) auf einer Zwischenebene 49 angeordneten Ventilator (47, 48) umfassen.

17. Gehäuse nach einem der Ansprüche 1 bis 16, **dadurch gekennzeichnet, dass** die Aussenseiten des Gehäuses (10) mit einer Sonnenstrahlung reflektierenden Beschichtung, vorzugsweise mit einem reflektierende Pigmente enthaltenden Lack, versehen sind.

## Claims

1. A cabinet-like housing (10), particularly for outside use, for the accommodation of heat-producing, particularly electric and/or electronic components, in which housing (10) an inner space (15) is surrounded by walls (11, 12, 13, 14), with these walls (11, 12, 13, 14) implemented at least partially as double-walled with an outer wall (110, 120) and an inner wall (111, 121) and an intermediate space (112, 122) located between the outer wall (110, 120) and the inner wall (111, 121), with the inner wall (111, 121) absorbing at least a part of the heat from the inner space (15) generated by the components, with first means (23, 24, 25, 26) present which generate an air flow through the intermediate space (112, 122) for cooling of the inner space (15), with the housing (10) having a roof (23, 24) which comprises an intermediate roof (23) and an upper roof (24) located over the intermediate roof (23), with the upper roof (24) at a distance from the intermediate roof (23) and reaching laterally over the intermediate roof (23), and with the intermediate roof reaching over the intermediate space (112, 122) of the double-walled wall (11, 12), which is open on top,
**characterized in that**
the upper roof extends laterally past the intermediate roof while leaving a slot-shaped opening (24a) free, the intermediate roof (23) terminates at the associated outer wall (110, 120), and second means (20) are located below and at a distance from the intermediate roof (23) which close off the inner space (15) on top and laterally terminate the inner wall (111, 121) of the double-walled wall (11, 12).

2. A housing according to claim 1, **characterized in that** the slot-shaped opening (24a) is directed downward.

3. A housing according to one of the claims 1 and 2, **characterized in that** the first means includes at least one ventilator (25, 26).

4. A housing according to claim 3, **characterized in that** the at least one ventilator (25, 26) is located in the intermediate roof (23), the intermediate space (112, 122) is open on top and is connected there with the at least one ventilator (25, 26), and the intermediate space (112, 122) is open on the bottom and is connected there with the surroundings of the housing (10).

5. A housing according to claim 4, **characterized in that** the at least one ventilator (25, 26) is installed in such a way that it sucks air out of the surroundings of the housing (10) through the intermediate space (112, 122) at the lower end of the intermediate space (112, 122) and blows this air into the intermediate space between the intermediate roof (23) and the upper roof (24).

6. A housing according to one of the claims 1 to 5, **characterized in that** the housing (10) comprises two side walls (11, 12), a forward wall (13), and a rear wall (14), and all walls (11, ..., 14) are implemented as double-walled and have the cooling air flow flowing through them.

7. A housing according to one of the claims 1 to 6, **characterized in that** all walls (11, ..., 14) implemented as double-walled are assembled from vertically positioned hollow chamber profiles (32, 33, 34).

8. A housing according to claim 7, **characterized in that** aluminum hollow profiles are used as the hollow chamber profiles (32, 33, 34).

9. A housing according to one of the claims 7 and 8, **characterized in that** the hollow chamber profiles (32, 33, 34) each have several adjacent chambers (37, 38).

10. A housing according to one of the claims 1 to 9, **characterized in that** the inner walls (111, 121) of the walls (11, ..., 14) implemented as double-walled have third means (39) for enlargement of the heat transfer area.

11. A housing according to claim 10, **characterized in that** the third means includes cooling ribs (39).

12. A housing according to claim 11, **characterized in that** the cooling ribs (39) are formed by a wave-shaped cross-sectional profile of the inner walls (111, 121).

13. A housing according to one of claims 1 to 12, **characterized in that** the second means comprises a sealing plate (20) which is provided with fourth means, preferably cooling ribs (44), for enlargement of the heat transfer area.

14. A housing according to one of the claims 1 to 13, **characterized in that** the inner space (15) is sealed to the outside and fifth means (45, ..., 48) are present in the inner space which cause a circulation of the air in the inner space (15) along the inner walls (111, 121) of the walls (11, ..., 14) implemented as double-walled.

15. A housing according to claim 14, **characterized in that** the circulation of the air along the inner walls (111, 121) occurs in the vertical direction and opposite to the direction of the air flow in the intermediate spaces (112, 122).

16. A housing according to one of the claims 14 and 15, **characterized in that** the fifth means comprises the guide plates (45, 46), located parallel to the inner walls (111, 121) and at a distance from them, and at least one ventilator (47, 48), located between the guide plates (45, 46) on an intermediate plane 49.

17. A housing according to one of the claims 1 to 16, **characterized in that** the outer sides of the housing (10) are provided with a coating which reflects solar radiation, preferably a lacquer containing a reflecting pigment.

## Revendications

1. Logement de type armoire (10), en particulier destiné à être mis en oeuvre à l'extérieur, pour recevoir des composants produisant de la chaleur, en particulier électrique et/ou électronique, logement (10) dans lequel une chambre intérieure (15) est entourée de parois (11, 12, 13, 14), lesquelles parois (11, 12, 13, 14) sont au moins formées partiellement avec des doubles parois, avec une paroi externe (110, 120) et une paroi interne (111, 121) et un espace interstitiel disposé entre la paroi externe (112, 122) et la paroi interne (111, 121), la paroi interne (111, 121) absorbant au moins une partie de la chaleur produite par les composants, provenant de la chambre intérieure (15), des premiers moyens (23, 24, 25, 26) étant disponibles qui produisent un courant d'air à travers l'espace interstitiel (112, 122) pour refroidir la chambre intérieure (15), le logement (10) comprenant un toit (23, 24) qui comporte un toit intermédiaire (23) et un toit supérieur (24) disposé sur le toit intermédiaire (23), qui est séparé du toit intermédiaire (23) et qui se porte latéralement au-dessus du toit intermédiaire (23), et le toit intermédiaire se portant au-dessus de l'espace interstitiel (112, 122) ouvert vers le haut de la paroi (11, 12) à double paroi,
**caractérisé en ce que**,
le toit supérieur se porte latéralement au-dessus du toit intermédiaire en dégageant une ouverture (24a) ayant la forme d'une fente, **en ce que** le toit intermédiaire (23) se termine par la paroi externe associée (110, 120) et que des deuxièmes moyens (20) sont disposés sous le toit intermédiaire (23) et séparés de celui-ci, lesquels ferment la chambre intérieure (15) vers le haut et se raccordent latéralement à la paroi interne (111, 121) de la paroi (11, 12) à double paroi.

2. Logement selon la revendication 1, **caractérisé en ce que** l'ouverture (24a) ayant la forme d'une fente est dirigée vers le bas.

3. Logement selon l'une quelconque des revendications 1 et 2, **caractérisé en ce que** les premiers moyens comportent au moins un ventilateur (25, 26).

4. Logement selon la revendication 3, **caractérisé en ce que**, au moins un ventilateur (25, 26) est disposé dans le toit intermédiaire (23), **en ce que** l'espace interstitiel (112, 122) est ouvert vers le haut et y est en communication avec ledit au moins un ventilateur (25, 26), et **en ce que** l'espace interstitiel (112, 122) est ouvert vers le haut et y est en communication avec l'environnement du logement (10).

5. Logement selon la revendication 4, **caractérisé en ce que** ledit au moins un ventilateur (25, 26) est monté, de sorte qu'il aspire l'air de l'environnement du logement (10) à travers l'espace interstitiel (112, 122), jusqu'à l'extrémité inférieure de l'espace interstitiel (112, 122) et qu'il souffle cet air dans l'espace interstitiel entre le toit intermédiaire (23) et le toit supérieur (24).

6. Logement selon l'une quelconque des revendications 1 à 5, **caractérisé en ce que** le logement (10) comporte deux parois latérales (11, 12), une paroi avant (13) et une paroi arrière (14), et que toutes les parois (11, ..., 14) sont formées avec des doubles parois et traversées par le courant d'air de refroidissement.

7. Logement selon l'une quelconque des revendications 1 à 6, **caractérisé en ce que** toutes les parois (11, ..., 14) formées avec des doubles parois se composent respectivement de profilés (32, 33, 34) à cavités, disposés verticalement.

8. Logement selon la revendication 7, **caractérisé en ce que** des profilés creux en aluminium sont utilisés en tant que profilés à cavités (32, 33, 34).

9. Logement selon l'une quelconque des revendications 7 et 8, **caractérisé en ce que** les profilés à cavités (32, 33, 34) comprennent chacun plusieurs chambres (37, 38) adjacentes.

10. Logement selon l'une quelconque des revendications 1 à 9, **caractérisé en ce que** les parois internes (111, 121) des parois (11, ..., 14) réalisées avec des doubles parois comprennent des troisièmes moyens (39) pour agrandir la surface de transfert thermique.

11. Logement selon la revendication 10, **caractérisé en ce que** les troisièmes moyens comportent des nervures de refroidissement (39).

12. Logement selon la revendication 11, **caractérisé en ce que** les nervures de refroidissement (39) sont formées par un profil de section ondulé des parois internes (111, 121).

13. Logement selon l'une quelconque des revendications 1 à 12, **caractérisé en ce que** les deuxièmes moyens comportent une tôle épaisse (20) qui est munie de quatrièmes moyens, de préférence des nervures de refroidissement (44), pour agrandir la surface de transfert thermique.

14. Logement selon l'une quelconque des revendications 1 à 13, **caractérisé en ce que** la chambre intérieure (15) est fermée vers l'extérieur et que des cinquièmes moyens (45, ..., 48) sont présents dans la chambre intérieure (15), qui provoquent une circulation de l'air se trouvant dans la chambre intérieure (15) le long des parois internes (111, 121) des parois (11, ..., 14) formées avec des doubles parois.

15. Logement selon la revendication 14, **caractérisé en ce que** la circulation de l'air a lieu le long des parois internes (111, 121) dans la direction verticale et à contre-courant par rapport à la direction du courant d'air dans les espaces interstitiels (112, 122).

16. Logement selon l'une quelconque des revendications 14 et 15, **caractérisé en ce que** les cinquièmes moyens comportent des déflecteurs (45, 46) disposés parallèlement aux parois internes (111, 121) et séparés de celles-ci et au moins un ventilateur (47, 48) disposé entre les déflecteurs (45, 46) sur un plan intermédiaire 49.

17. Logement selon l'une quelconque des revendications 1 à 16, **caractérisé en ce que** les côtés extérieurs du logement (10) sont munis d'une couche réfléchissant le rayonnement solaire, de préférence d'une laque contenant des pigments réfléchissants.
